(19) Europäisches Patentamt
European Patent Office
Office européen des brevets

(11) **EP 2 015 083 B1**

(12) **EUROPÄISCHE PATENTSCHRIFT**

(45) Veröffentlichungstag und Bekanntmachung des Hinweises auf die Patenterteilung:
**24.04.2019   Patentblatt 2019/17**

(51) Int Cl.:
**G01R 23/16** *(2006.01)*     **G01R 29/26** *(2006.01)*

(21) Anmeldenummer: **08011999.3**

(22) Anmeldetag: **03.07.2008**

(54) **Verfahren und Vorrichtung zur Optimierung der Messzeit für Rauschanalysatoren oder Spektrumanalysatoren mit Kreuzkorrelationsverfahren**

Method and device for optimising the measuring time for noise or spectrum analysers using cross correlation methods

Procédé et dispositif d'optimisation du temps de mesure pour analyseurs de bruit ou de spectre utilisant des procédés de corrélation croisée

(84) Benannte Vertragsstaaten:
**DE FR GB**

(30) Priorität: **12.07.2007   DE 102007033446**
**02.10.2007   DE 102007047138**

(43) Veröffentlichungstag der Anmeldung:
**14.01.2009   Patentblatt 2009/03**

(73) Patentinhaber: **Rohde & Schwarz GmbH & Co. KG**
**81671 München (DE)**

(72) Erfinder:
• **Feldhaus, Gregor, Dr.**
**81669 München (DE)**
• **Eckert, Hagen**
**86415 Mering (DE)**

(74) Vertreter: **Körfer, Thomas et al**
**Mitscherlich PartmbB**
**Patent- und Rechtsanwälte**
**Sonnenstrasse 33**
**80331 München (DE)**

(56) Entgegenhaltungen:
WO-A1-2006/034791     DE-A1- 10 114 410
GB-A- 2 426 597     JP-A- 8 184 624
US-A1- 2005 238 094

**Beschreibung**

Die Erfindung betrifft ein Verfahren und eine Vorrichtung zur Messung des Leistungsdichte - Spektrums beispielsweise in einem Netzwerkanalysator, einem Spektrumanalysator oder einem Phasenrauschmessplatz.

Das Kreuzkorrelationsverfahren ist ein z. B. aus der US 2005/0238094 A1 bekanntes Verfahren zur Messung von Spektren mit Leistungsdichten unterhalb der Eigenrauschleistungsdichte des Messinstruments. Das Messsignal wird dazu auf zwei Eingangspfaden aufgezeichnet. Durch Mittelung der Spektren werden die unkorrelierten Anteile des Messinstruments gegenüber dem Eingangssignal gedämpft. In den bisherigen Realisierungen muss die Anzahl der Mittelungen im voraus eingegeben werden und es gibt keine Rückmeldung, wieweit die unkorrelierten Anteile unterdrückt wurden. Ein ähnliches Verfahren ist aus GB2426597 bekannt.

Der Anmeldung liegt die Aufgabe zugrunde, ein Verfahren und eine Vorrichtung zu schaffen, um die Anzahl der Mittelungen automatisch zu bestimmen und damit die Messzeit zu minimieren. Die Aufgabe wird such die Merkmale des Anspruchs 1 bezüglich des Verfahrens und durch die Merkmale des Anspruchs 8 bezüglich der Vorrichtung gelöst. Die Unteransprüche enthalten vorteilhafte Weiterbildungen. Der Erfindung liegt die Erkenntnis zugrunde, dass durch Berechnen einer speziellen Metrik aus den fouriertransformierten Signalen der beiden Pfade, die für die Kreuzkorrelation verwendet werden, sowie der Anzahl der bereits durchgeführten Mittelungen ein Abbruchkriterium geschaffen wird, dass eine Entscheidung darüber ermöglicht, ob eine weitere Mittelung, d. h. eine Verlängerung der Kreuzkorrelationsslänge, noch sinnvoll ist, bzw. ob der damit verbundene Aufwand noch in Relation zu der dabei erzielten Erhöhung der Genauigkeit steht.

Unter Anzahl der Mitteilungen wird im Rahmen dieser Anmeldung die Anzahl $N$ der Werte $y_1(k)$ und $y_2^*(k)$ verstanden, die in der Summe der diskreten Kreuzkorrelationsfunktion

$$\frac{1}{N}\sum_{i=1}^{N} y_1(k)\cdot y_2^*(k)$$

eingehen, also die Länge der Kreuzkorrelation.

Die Metrik kann z. B. als auf dem Display angezeigte Wert dem Benutzer zur Verfügung gestellt werden, der dann selbstständig über den Abbruch des Verfahrens entscheidet. Bevorzugt erfolgt aber ein automatischer Abbruch, wenn einerseits die Metrik einen gewissen Schwellwert überschreitet und andererseits zumindest eine gewisse Mindestanzahl von Mittelungen bereites durchgeführt wurde, um einen zufälligen Abbruch durch ein zufälliges Überschreiten des Schwellwerts zu vermeiden.

Das Verfahren wird vorzugsweise für alle Bins, d. h. für alle diskreten Frequenzwerte der diskreten Fouriertransformationen durchgeführt. Als Gesamtmetrik, die als Abbruchkriterium herangezogen wird, kann dann entweder das Minimum aller für alle Bins berechneten Einzelmetriken oder aber der Mittelwert über alle zu den Bins berechneten Metriken verwendet werden.

Die Unteransprüche der erfindungsgemäßen Vorrichtung betreffen eine vorteilhafte konkrete Realisierung der Berechnungseinrichtung.

Die Erfindung wird nachfolgend unter Bezugnahme auf ein in der Zeichnung dargestelltes Ausführungsbeispiel näher beschrieben. In der Zeichnung zeigen:

Fig. 1    ein Blockschaltbild eines Ausführungsbeispiels der Kreuzkorrelationsmessung;

Fig. 2    ein Beispiel zur Entwicklung des Erwartungswertes;

Fig. 3    das Messergebnis und die zugehörige Metrik und

Fig. 4    ein Blockschaltbild eines Ausführungsbeispiels zur Metrikberechnung

Im Rahmen dieser Anmeldung werden folgende Symbole verwendet:

$N$      Anzahl Mittelungen
$\mu$      Mittelwert einer Zufallsvariablen
$\sigma$      Standardabweichung einer Zufallsvariablen
$\sigma^2$      Varianz einer Zufallsvariablen
$E\{x\}$      Erwartungswert der Zufallsvariable $x$
$L$      Metrik

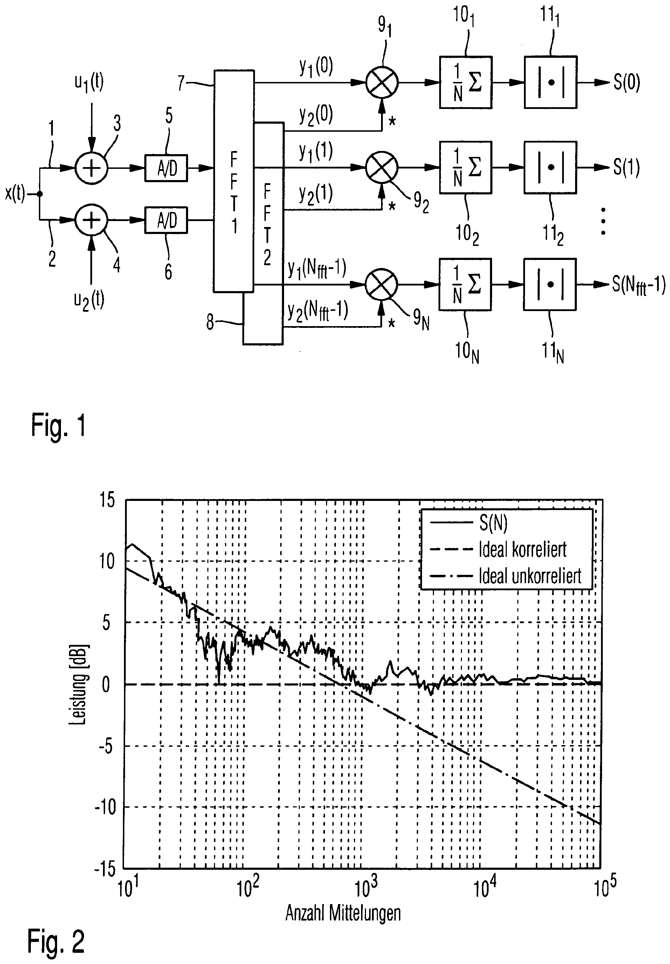

Fig. 1 zeigt ein Blockschaltbild einer Spektrumsmessung mit Kreuzkorrelation, wie es bisher üblich ist. Das Eingangssignal $x(t)$ wird auf zwei Pfade 1,2 aufgeteilt.

Beiden Pfaden 1,2 addieren sich während der internen analogen Signalverarbeitung die unabhängigen Stör-signale $u_1(t)$ und $\mu_2(t)$. Dies ist durch die Addierer 3,4 veranschaulicht. Die in Analog/Digital-Wandlern 5,6 abgetasteten Signale werden auf zwei getrennte FFT-Blöcke 7,8 gegeben, die die Transformation in den Frequenzbereich übernehmen. Zusammengehörige FFT-Bins beider FFT-Blöcke 7,8 werden in den Multiplizierern $9_1$, $9_2$...$9_N$ konjugiert komplex miteinender multipliziert und in den Mittelwertbildern $10_1$, $10_2$... $10_N$ über $N$ FFTs gemittelt. Zur Anzeige kommt der Betrag der gemittelten Spektralwerte. Der Betragsoperator der Betragsbilder $11_1$, $11_2$... $11_N$ ist sinnvoll, um garantiert positive Leistungswerte für eine logarithmische Skala zu erhalten.

Die Ausgangssignale des $k$-ten FFT-Bins $y_1(k)$ und $y_2(k)$ lassen sich aufspalten zu

$$(\text{Gl. 1}) \qquad \begin{aligned} y_1 &= a + n_1 \\ y_2 &= a + n_2 \end{aligned}$$

Der Frequenzindex $k$ ist beliebig und wird in den folgenden Betrachtungen zur Statistik weggelassen. Unter der Annahme von reellen mittelwertfreien gaußschen Rauschprozessen $x(t)$, $u_1(t)$ und $u_2(t)$ sind $a$, $n_1$ und $n_2$ komplexe mittelwertfreie normalverteilte Zufallsvariablen mit den Varianzen $\sigma_a^2$, $\sigma_{n1}^2$ und $\sigma_{n2}^2$. Die beiden Störkomponenten $n_1$ und $n_2$ sind zueinander und zur Eingangsgröße $a$ unkorreliert. Die gesuchte Ausgangsgröße ist der Erwartungswert der Leistung der gemeinsamen korrelierten Komponente $\sigma_a^2$.

Die tatsächlich angezeigte Ausgangsgröße ist der Betrag der gemittelten Produkte.

Der Index $i$ beschreibt in Zeitrichtung aufeinander folgende FFT-Ergebnisse.

$$(\text{Gl. 2}) \qquad \begin{aligned} S &= \left| \frac{1}{N} \sum_{i=0}^{N-1} y_{1i} \cdot y_{2i}^* \right| \\ &= \left| \frac{1}{N} \sum_{i=0}^{N-1} |a_i|^2 + a_i \cdot n_{2i}^* + a_i^* \cdot n_{1i} + n_{1i} \cdot n_{2i}^* \right| \end{aligned} \quad .$$

Für die einzelnen Summanden gelten die folgenden Verteilungen:

- $\dfrac{1}{N} \sum_{i=0}^{N-1} |a_i|^2$ ist chi-quadrat verteilt mit $\mu = \sigma_a^2$ und $\sigma^2 = \dfrac{1}{N} \sigma_a^4$.

- $\dfrac{1}{N} \sum_{i=0}^{N-1} a_i \cdot n_{2i}^*$ ist nach dem zentralen Grenzwertsatz für große $N$ normalverteilt mit $\mu = 0$ und

  $\sigma^2 = \dfrac{1}{N} \sigma_a^2 \cdot \sigma_{n2}^2$.

- $\dfrac{1}{N} \sum_{i=0}^{N-1} a_i^* \cdot n_{1i}$ ist nach dem zentralen Grenzwertsatz für große $N$ normalverteilt mit $\mu = 0$ und

  $\sigma^2 = \dfrac{1}{N} \sigma_a^2 \cdot \sigma_{n1}^2$.

- $\dfrac{1}{N} \sum_{i=0}^{N-1} n_{1i} \cdot n_{2i}^*$ ist nach dem zentralen Grenzwertsatz für große $N$ normalverteilt mit $\mu = 0$ und

$$\sigma^2 = \frac{1}{N}\sigma_{n1}^2 \cdot \sigma_{n2}^2 \ .$$

Für eine weitergehende Analyse der Statistik des angezeigten Ausgangswertes werden zwei Spezialfälle untersucht.

1. Die unkorrelierten Anteile ($n_1$, $n_2$) dominieren. $\quad S = \left| \frac{1}{N}\sum_{i=0}^{N-1} n_{1i} \cdot n_{2i}^* \right| \quad$ ist Rayleigh-verteilt mit

$$\mu = \sqrt{\frac{\pi}{2 \cdot N}} \cdot \sigma_{n1} \cdot \sigma_{n2} \quad \text{und} \quad \sigma^2 = \frac{4-\pi}{4N}\sigma_{n1}^2 \cdot \sigma_{n2}^2 \ ,$$

d.h. der Erwartungswert des angezeigten Signals sinkt proportional zu $\sqrt{1/N}$ .

2. Die korrelierten Anteile ($a$) dominieren. $\quad S = \left| \frac{1}{N}\sum_{i=0}^{N-1}|a_i|^2 \right| = \frac{1}{N}\sum_{i=0}^{N-1}|a_i|^2 \quad$ ist chi-quadrat verteilt mit $\mu = \sigma_a^2$

$$\text{und} \quad \sigma^2 = \frac{1}{N}\sigma_a^4 \ ,$$

d.h. der Erwartungswert des angezeigten Signals ist ein Schätzwert für die gesuchte Größe $\sigma_a^2$ .

Im allgemeinen ergibt sich somit ein zweigeteilter Verlauf des Ausgangssignals als Funktion der Anzahl der Mittelungen. Solange die unkorrelierten Anteile dominieren, d.h. es wurde noch nicht genügend gemittelt, sinkt der Erwartungswert des Ausgangs mit dem Faktor $1/\sqrt{N}$ . Die Standardabweichung sinkt mit dem gleichen Faktor, was jedoch auf einer logarithmischen Skala nicht zu einer optischen Glättung der Kurve führt.

Wenn schließlich soweit gemittelt wurde, dass die korrelierten Anteile gegenüber den unkorrelierten Anteilen dominieren, läuft der Erwartungswert auf den gesuchten Wert $\sigma_a^2$ ein. Die Standardabweichung sinkt weiter mit dem Faktor $1/\sqrt{N}$ , so dass nun auch optisch eine Glättung der Kurve erfolgt.

Fig. 2 zeigt beispielhaft eine Realisierung des Zufallsprozesses $S(N)$ mit $\sigma_a^2 = 0\,\text{dB}$ und $\sigma_{n1}^2 = \sigma_{n2}^2 = 13\,\text{dB}$ und die zugehörigen theoretischen Kurven der Erwartungswerte für ein rein unkorreliertes Eingangssignal ($a = 0$) und ein rein korreliertes Eingangssignal ($n_1 = n_2 = 0$).

Nach den obigen Überlegungen ist ein Sinken der angezeigten Ausgangsleistung solange zu erwarten, wie das unkorrelierte Signal gegenüber dem korrelierten Signal dominiert. Eine Glättung der Kurve findet erst statt, wenn der Erwartungswert gegen den Endwert einläuft. Im Beispiel der Fig. 2 ist ein Abbruch der Messung erst ab etwa 1000 Mittelungen sinnvoll, wenn man einen erwartungstreuen Schätzwert der Leistung verlangt.

Bei den bisher bekannten Realisierungen des Kreuzkorrelationsverfahrens wird die Mittelungslänge im voraus eingegeben. Das Ergebnis wird erst zur Anzeige gebracht, wenn alle Mittelungen durchlaufen sind. Es gibt keine Rückmeldung, ob in dem Ergebnis noch die unkorrelierten Anteile überwiegen oder bereits der Endwert erreicht wurde. Der Benutzer kann nur optisch anhand der Varianz der angezeigten Spektrumskurve entscheiden, ob eine Erhöhung der Mittelungslänge sinnvoll ist. Dieses Verfahren ist ungenau und nicht für einen automatisierten Messablauf geeignet. Wenn dagegen die Mittelungslänge immer auf das Maximum eingestellt wird, verschenkt man wertvolle Messzeit.

Erfindungsgemäß wird somit folgende Erweiterung der Kreuzkorrelationsmessung vorgenommen:

1. Automatische Berechnung einer Metrik für die zu erwartende Verbesserung bei Erhöhung der Mittelungslänge.
2. Automatischer oder manueller Abbruch der Messung, wenn keine entscheidenden Verbesserungen mehr zu erwarten sind.

Nach Fig. 2 ist ein Abbruch der Mittelung erst dann sinnvoll, wenn die abfallende Gerade des unkorrelierten Signalanteils deutlich unterhalb der konstanten Gerade des korrelierten Signalanteils liegt. Um eine Metrik für ein Abbruchkriterium zu bestimmen, muss Gl. 2 auf die unbekannten Leistungswerte normiert werden.

Die vorgeschlagene Metrik lautet

$$(\text{Gl. 3}) \qquad L = N \cdot \frac{\left| \frac{1}{N} \sum_{i=0}^{N-1} y_{1i} \cdot y_{2i}^* \right|^2}{\frac{1}{N} \sum_{i=0}^{N-1} |y_{1i}|^2 \cdot \frac{1}{N} \sum_{i=0}^{N-1} |y_{2i}|^2} = N \cdot \frac{\left| \sum_{i=0}^{N-1} y_{1i} \cdot y_{2i}^* \right|^2}{\sum_{i=0}^{N-1} |y_{1i}|^2 \cdot \sum_{i=0}^{N-1} |y_{2i}|^2} \quad .$$

Unter Anwendung der Cauchy-Schwarzschen Ungleichung kann sofort eine obere Schranke der Metrik aus (Gl. 3) angegeben werden:

$$(\text{Gl. 4}) \qquad L \leq N \quad .$$

Der Zähler der Metrik entspricht dem Quadrat der angezeigten Messgröße aus (Gl. 2). Der Nenner dient zur Normierung des Messwerts und hat den Erwartungswert

$$(\text{Gl. 5}) \qquad E\left\{ \frac{1}{N} \sum_{i=0}^{N-1} |y_{1i}|^2 \cdot \frac{1}{N} \sum_{i=0}^{N-1} |y_{2i}|^2 \right\} = \left( \sigma_a^2 + \sigma_{n1}^2 \right) \cdot \left( \sigma_a^2 + \sigma_{n2}^2 \right)$$

$$= \sigma_a^4 + \sigma_a^2 \cdot \sigma_{n1}^2 + \sigma_a^2 \cdot \sigma_{n2}^2 + \sigma_{n1}^2 \cdot \sigma_{n2}^2$$

Nun soll der Effekt der Normierung bei drei Spezialfällen untersucht werden:

1. Die korrelierten Anteile überwiegen unabhängig von der Anzahl der Mittelungen, d.h. $\sigma_a^2 \gg \sigma_{n1} \cdot \sigma_{n2}$ :

$$L \approx N \cdot \frac{\left| \sum_{i=0}^{N-1} |a_i|^2 \right|^2}{\sum_{i=0}^{N-1} |a_i|^2 \cdot \sum_{i=0}^{N-1} |a_i|^2} \Rightarrow E\{L\} \approx N \cdot \frac{\sigma_a^4}{\sigma_a^2 \cdot \sigma_a^2} = N \quad .$$

2. Die unkorrelierten Anteile überwiegen und es wurde noch nicht genug gemittelt, um dieses Verhältnis umzudrehen, d.h. $\sqrt{\frac{1}{N}} \cdot \sigma_{n1} \cdot \sigma_{n2} \gg \sigma_a^2$, impliziert $\sigma_{n1} \cdot \sigma_{n2} \gg \sigma_a^2$ :

$$L \approx N \cdot \frac{\left| \sum_{i=0}^{N-1} n_{1i} \cdot n_{2i}^* \right|^2}{\sum_{i=0}^{N-1} |n_{1i}|^2 \cdot \sum_{i=0}^{N-1} |n_{2i}|^2} \Rightarrow E\{L\} \approx N \cdot \frac{\frac{1}{N} \cdot \sigma_{n1}^2 \cdot \sigma_{n2}^2}{\sigma_{n1}^2 \cdot \sigma_{n2}^2} = 1 \quad .$$

3. Die unkorrelierten Anteile überwiegen, aber durch genügende Mittelungen wurde dieses Verhältnis umgedreht,

d.h. $\sqrt{\dfrac{1}{N}} \cdot \sigma_{n1} \cdot \sigma_{n2} \ll \sigma_a^2$ , aber $\sigma_{n1} \cdot \sigma_{n2} \gg \sigma_a^2$ :

$$L \approx N \cdot \frac{\left| \sum_{i=0}^{N-1} |a_i|^2 \right|^2}{\sum_{i=0}^{N-1} |n_{1i}|^2 \cdot \sum_{i=0}^{N-1} |n_{2i}|^2} \Rightarrow E\{L\} \approx N \cdot \frac{\sigma_a^4}{\sigma_{n1}^2 \cdot \sigma_{n2}^2} \ .$$

Solange noch Verbesserungen durch Erhöhung der Mittelungslänge zu erwarten sind, bleibt die Metrik $L$ ungefähr auf 1. Nur wenn durch Mittelung der Einfluss der unkorrelierten Anteile vernachlässigbar geworden ist, steigt die Metrik proportional zur Mittelungslänge $N$.

Die Messung kann abgebrochen werden, wenn die Metrik deutlich über 1 liegt:

(Gl. 6) $\qquad L > R$ mit $R \gg 1$

In der Praxis hat sich ein Wert von mindestens $R = 10$ bewährt. Da die Metrik selber eine Zufallsgröße ist, darf der Wert $R$ nicht zu klein gewählt werden, um die Wahrscheinlichkeit eines zufälligen Überschreitens zu minimieren. Des Weiteren beruhen die vorstehenden Statistiken zum Teil auf dem zentralen Grenzwertsatz und erfordern daher schon eine gewisse Mittelungslänge für ihre Gültigkeit. Als in der Praxis sinnvoll hat sich eine minimale Mittelungslänge von $N_{min} = 100$ herausgestellt, bevor mit der Evaluierung der Metrik begonnen wird.

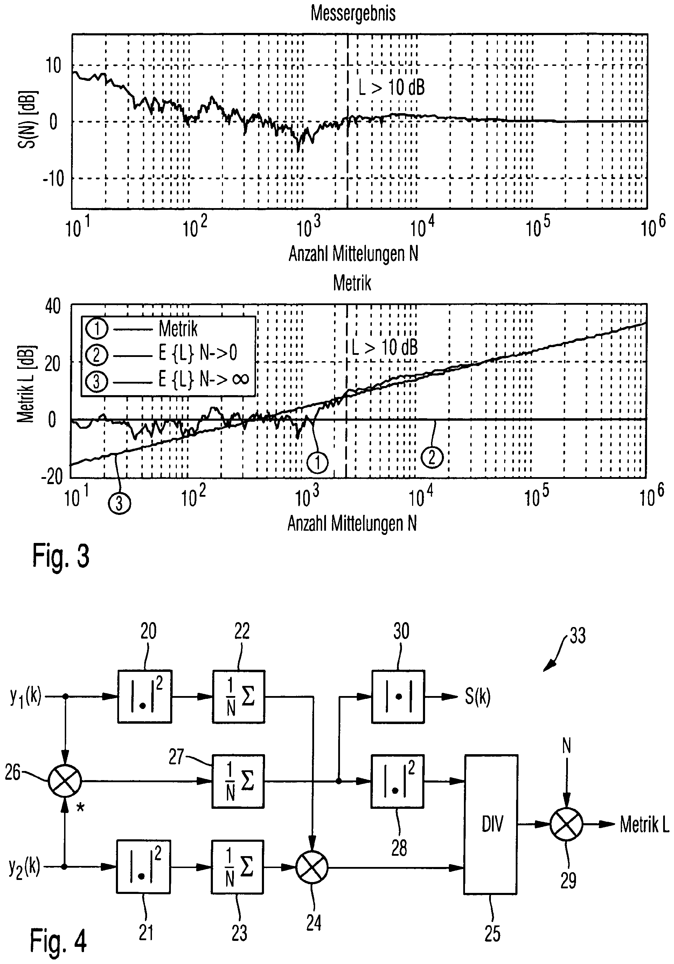

Fig. 3 zeigt beispielhaft eine Messung und die zugehörige Metrik mit $\sigma_a^2 = 0\,\mathrm{dB}$ und $\sigma_{n1}^2 = \sigma_{n2}^2 = 13\,\mathrm{dB}$ . Die senkrechte Linie markiert die Anzahl Mittelungen, ab der die Metrik den Wert $R = 10$ überschreitet. Ein entsprechend eingestelltes Abbruchkriterium würde hier die Messung stoppen.

Fig. 4 zeigt das Blockschaltbild zur Berechnung der Metrik. Die Einrichtung 33 zur Berechnung der Metrik $L$ übernimmt die Werte $y_1(k)$ und $y_2(k)$ an den Bins der FFT-Blöcke 7 und 8. In Fig. 4 wird nur der FFT-Bin $k$ betrachtet. Von dem Wert $y_1(k)$ wird im Betragsquadratbilder 20 das Betragsquadrat gebildet und im anschließenden Mittelwertbilder 22 der Mittelwert gebildet und dann einem ersten Eingang des Multiplizierers 24 zugeführt. Entsprechend wird in dem Betragsquadratbilder 21 das Betragsquadrat des Wertes $y_2(k)$ gebildet und in dem anschließenden Mittelwertbilder 23 der Mittelwert gebildet, der einem zweiten Eingang des Multiplizierers 24 zugeführt wird. In dem Multiplizierer 24 werden dann die gemittelten Betragsquadrate der Werte $y_1(k)$ und $y_2(k)$ miteinander multipliziert und dem Nenner-Eingang des Dividierers 25 zugeführt.

In einen Multiplizierer 26 werden der Wert $y_1(k)$ und der konjugiert komplexe Wert $y_2^\cdot(k)$ von $y_2(k)$ miteinander multipliziert und dem Mittelwertbilder 27 zugeführt, der daraus den Mittelwert bildet. Die Ausgangswerte des Mittelwertbilders 27 werden einerseits dem Betragsquadratbilder 28 zugeführt, der daraus die Betragsquadrate bildet und diese dem Zähler-Eingang des Dividierers 25 zuführt. Der Dividierer 25 bildet den Quotienten aus dem Wert, der an dem Zählereingang anliegt, und dem Wert, der an dem Nenner-Eingang anliegt. Der Ausgangswert des Dividierers 25 wird in einem Multipliezierer 29 mit der Anzahl der Mittelungen $N$ multipliziert, so dass am Ausgang des Multiplizierers 29 die Metrik $L$ zur Verfügung steht. Andererseits ist der Mittelwertbilder 27 mit dem Betragsbilder 30 verbunden, so dass am Ausgang des Betragsbilders 30 die Spektralwerte $S(k)$ zur Verfügung stehen, die beispielsweise auf einer nicht dargestellten Anzeigeeinrichtung angezeigt werden können.

Diese Blöcke müssen für jeden FFT-Bin realisiert werden. Die Akkumulatoren der Mittelwertbilder 22, 23 und 27 werden bei jedem FFT-Ergebnis aktualisiert. Dies ist jedoch für die eigentliche Berechnung und Auswertung der Metrik $L$ in den Blöcken 24, 25, 28 und 29 nicht nötig. Um die erwartete Zeitersparnis nicht durch zusätzliche Rechenzeit wieder aufzubrauchen, bietet es sich an, die Metrikberechnung und Auswertung nur zu bestimmten diskreten Mittelungslängen vorzunehmen. Für die Anwendung in einem Phasenrauschmessplatz hat sich die Überprüfung der Metrik zu den Mittelungszeitpunkten $N = 100, 300, 1000, 3000, 10000$ und $30000$ bewährt. Wenn zu diesen Zeitpunkten die Bedingung aus G1. 6 erfüllt ist, wird die Messung abgebrochen.

In der Regel macht es keinen Sinn, die Mittelungslänge eines jeden FFT-Bins einzeln einzustellen, da die Messzeit durch die Datenaufnahme und die FFT-Operation bestimmt wird.

In diesem Fall muss die Metrik über alle FFT-Bins gemeinsam ausgewertet werden, wobei es mehrere Möglichkeiten gibt:

1. Die Gesamtmetrik ist die minimale Metrik über alle FFT-Bins

$$L_{\text{gesamt}} = \min\big(L(k)\big) .$$

2. Die Gesamtmetrik ist die mittlere Metrik über alle FFT-Bins

$$L_{\text{gesamt}} = \frac{1}{N_{\text{FFT}}} \cdot \sum_{k=0}^{N_{\text{FFT}}-1} L(k) .$$

Möglichkeit 1 ist vorzuziehen, wenn das Messsignal und die Eigenrauschsignale einen unterschiedlichen Frequenzgang aufweisen und sichergestellt werden soll, dass über den gesamten Frequenzbereich die unkorrelierten Anteile genügend gedämpft werden. Einige Messgeräte, z.B. Phasenrauschmess-plätze, teilen das Spektrum in Dekaden oder Halbdekaden auf und ermöglichen es so, die Mittelungslänge für jeden dieser Teilbereiche einzeln einzustellen. In diesem Fall muss die Metrik für alle FFT-Bins eines Teilbereiches gemeinsam evaluiert werden. Jeder Teilbereich für sich kann aber eine eigene Mittelungslänge aufweisen.

Die Metrik kann entweder selber ein Messergebnis sein oder zur Überprüfung eines Abbruchkriteriums herangezogen werden.

Die Metrik wird dem Benutzer des Messgerätes als Ergebnis übergeben und dient als Rückmeldung, ob das unkorrelierte oder das korrelierte Signal überwiegt. Alternativ wird die Metrik gemäß Gl. 6 als Abbruchkriterium verwendet. Wenn die Metrik einen zuvor festgelegten Wert $R$ überschreitet, wird die Mittelung automatisch abgebrochen und die Messzeit somit optimiert.

Es kann sinnvoll sein, eine obere Grenze der Mittelungslänge vorzugeben, um die Messzeit nach oben hin zu begrenzen.

Die Erfindung ist nicht auf das dargestellte Ausführungsbeispiel beschränkt. Die Berechnungseinrichtung kann auch in anderer Weise, als in Fig. 4 dargestellt, realisiert sein. Beispielsweise kann anstatt der Multiplikation des ersten fouriertransformierten Signals $y_1(k)$ mit dem konjugiert komplexen zweiten fouriertransformierten Signal $y_2^*(k)$ auch das konjugiert komplexe erste fouriertransformierte Signal $y_1^*(k)$ mit dem zweiten fouriertransformierten Signal $y_2(k)$ multipliziert werden. Es können auch mehr als zwei Signalpfade vorhanden sein, wobei die Kreuzkorrelation dann paarweise über alle Signalpfade durchgeführt wird. Alle beschriebenen und/oder gezeichneten Merkmale sind im Rahmen der Erfindung beliebig miteinander kombinierbar.

## Patentansprüche

1.  Verfahren zur Messung des Leistungsdichte-Spektrums eines Eingangssignals (x(t)) mit folgenden Verfahrensschritten:

Durchführen einer ersten Fouriertransformation (7) in einem ersten Pfad (1) zur Erzeugung eines ersten fouriertransformierten Signals ($y_1$(k)),
Durchführen einer zweiten Fouriertransformation (8) in einem zweiten Pfad (2) zur Erzeugung eines zweiten fouriertransformierten Signals ($y_2$(k)),
Durchführen einer Kreuzkorrelation ($9_1, 10_1, 9_2, 10_2, ..., 9_N, 10_N$) aus dem ersten fouriertransformierten Signal ($y_1$(k)) und dem zweiten fouriertransformierten Signal ($y_2$(k)) über eine Anzahl (N) von Mittelungen,
**gekennzeichnet durch**
Berechnen (33) einer Metrik (L) aus dem ersten fouriertransformierten Signal ($y_1$(k)) und dem zweiten fouriertransformierten Signal ($y_2$(k)) sowie der bereits durchgeführten Anzahl (N) der Mittelungen als Abbruchkriterium zur Durchführung weiterer Mittelungen.

2.  Verfahren nach Anspruch 1,
wobei die Metrik L gemäß der Formel

$$L = N \cdot \frac{\left| \sum\limits_{i=0}^{N-1} y_{1i} \cdot y_{2i}^{*} \right|^{2}}{\sum\limits_{i=0}^{N-1} |y_{1i}|^{2} \cdot \sum\limits_{i=0}^{N-1} |y_{2i}|^{2}}$$

berechnet wird, wobei $y_{1i}$ der i-te Wert des ersten fouriertransformierten Signals, $y_{2i}$ der i-te Wert des zweiten fouriertransformierten Signals und N die Anzahl der Mittelungen ist.

3. Verfahren nach Anspruch 1 oder 2,
wobei das Verfahren abgebrochen wird, wenn die Metrik (L) größer als ein vorgegebener Schwellwert (R) ist, nachdem zumindest eine Mindestanzahl ($N_{min}$) von Mittelungen durchgeführt wurde.

4. Verfahren nach Anspruch 3,
wobei der Schwellwert (R) mindestens 10 beträgt und/oder wobei die Mindestanzahl ($N_{min}$) von Mittelungen mindestens 100 beträgt.

5. Verfahren nach einem der Ansprüche 1 bis 4,
wobei das verrauschte Eingangssignal ($x(t)+u_1(t)$; $x(t)+u_2(t)$) in jedem Pfad (1;2) separat digital abgetastet (5;6) wird,
wobei jeweils in jedem Pfad (1;2) eine diskrete Fouriertransformation (7;8) durchgeführt wird und
wobei die Metrik für jeden Bin (k) des diskreten ersten fouriertransformierten Signals und des diskreten zweiten fouriertransformierten Signals berechnet wird.

6. Verfahren nach Anspruch 5,
wobei als eine Gesamtmetrik ($L_{gesamt}$) das Minimum aller für alle Bins (k) berechneten Metriken (L(k)) verwendet wird.

7. Verfahren nach Anspruch 5,
wobei als eine Gesamtmetrik ($L_{gesamt}$) der Mittelwert aller für alle Bins (k) berechneten Metriken (L(k)) verwendet wird.

8. Vorrichtung zur Messung des Leistungsdichte-Spektrums eines Eingangssignals (x(t)) mit
einer ersten Fouriertransformations-Einrichtung (7), die in einem ersten Pfad (1) eine erste Fouriertransformation zur Erzeugung eines ersten fouriertransformierten Signals ($y_1(k)$) durchführt, einer zweiten Fouriertransformations-Einrichtung (8), die in einem zweiten Pfad (2) eine zweite Fouriertransformation zur Erzeugung eines zweiten fouriertransformierten Signals ($y_2(k)$) durchführt, und einem Kreuzkorrelator ($9_1, 10_1, 9_2, 10_2, ..., 9_N, 10_N$), der eine Kreuzkorrelation aus dem ersten fouriertransformierten Signal ($y_1(k)$) und dem zweiten fouriertransformierten Signal ($y_2(k)$) über eine Anzahl (N) von Mittelungen durchführt,
**gekennzeichnet durch**
eine Berechnungseinrichtung (33) zum Berechnen einer Metrik (L) aus dem ersten fouriertransformierten Signal ($y_1(k)$) und dem zweiten fouriertransformierten Signal ($y_2(k)$) sowie der bereits durchgeführten Anzahl (N) der Mittelungen als Abbruchkriterium zur Durchführung weiterer Mittelungen.

9. Vorrichtung nach Anspruch 8,
wobei die Berechnungseinrichtung (33) eine erste Betragsquadratbildungs-Einrichtung (20) zur Bildung des Betragsquadrats des ersten fouriertransformierten Signal ($y_1(k)$) und eine zweite Betragsquadratbildungs-Einrichtung (21) zur Bildung des Betragsquadrats des zweiten fouriertransformierten Signal ($y_2(k)$) aufweist.

10. Vorrichtung nach Anspruch 9,
wobei die Berechnungseinrichtung (33) eine erste Mittelungs-Einrichtung (22) zur Mittelung der Ausgangswerte der ersten Betragsquadratbildungs-Einrichtung (20) und eine zweite Mittelungs-Einrichtung (23) zur Mittelung der Ausgangswerte der zweiten Betragsquadratbildungs-Einrichtung (21) aufweist.

11. Vorrichtung nach Anspruch 10, wobei die Berechnungseinrichtung (33) einen ersten Multiplizierer (24) zum Multiplizieren der Ausgangswerte der ersten Mittelungs-Einrichtung (22) und der Ausgangswerte der zweiten Mittelungs-Einrichtung (23) aufweist.

12. Vorrichtung nach Anspruch 11,
wobei die Berechnungseinrichtung (33) einen zweiten Multiplizierer (26) zum Multiplizieren des ersten fouriertrans-

formierten Signals ($y_1$(k)) und des konjugiertkomplexen zweiten fouriertransformierten Signals ($y_2$*(k)) oder zum Multiplizieren des zweiten fouriertransformierten Signals ($y_2$(k)) und des konjugiertkomplexen ersten fouriertransformierten Signals ($y_1$*(k)) aufweist.

**13.** Vorrichtung nach Anspruch 12,
wobei die Berechnungseinrichtung (33) eine dritte Mittelungs-Einrichtung (27) zur Mittelung der Ausgangswerte des zweiten Multiplizierers (26) aufweist.

**14.** Vorrichtung nach Anspruch 13,
wobei die Berechnungseinrichtung (33) eine dritte Betragsquadratbildungs-Einrichtung (28) zur Bildung des Betragsquadrats der Ausgangswerte der dritten Mittelungs-Einrichtung (27) aufweist.

**15.** Vorrichtung nach Anspruch 14,
wobei die Berechnungseinrichtung (33) eine Divisions-Einrichtung (25) aufweist, die den Quotienten aus den Ausgangswerten der dritten Betragsquadratbildungs-Einrichtung (28) und den Ausgangswerten des ersten Multiplizierers (24) bildet.

**16.** Vorrichtung nach Anspruch 15,
wobei die Berechnungseinrichtung (33) einen dritten Multiplizierer (29) zum Multiplizieren der Ausgangswerte der Divisions-Einrichtung (25) mit der Anzahl der Mittelungen (N) aufweist.

**Claims**

**1.** Method for measuring the power density spectrum of an input signal (x(t)) with the following method steps:

implementation of a first Fourier transformation (7) in a first path (1) to generate a first Fourier-transformed signal ($y_1$(k)),
implementation of a second Fourier transformation (8) in a second path (2) to generate a second Fourier-transformed signal ($y_2$(k)),
implementation of a cross-correlation ($9_1$, $10_1$, $9_2$, $10_2$, ..., $9_N$, $10_N$) of the first Fourier-transformed signal ($y_1$(k)) and the second Fourier-transformed signal ($y_2$(k)) over a number (N) of averagings,
**characterised by**
calculation of a metric (L) from the first Fourier-transformed signal ($y_1$(k)) and the second Fourier-transformed signal ($y_2$(k)) and the already implemented number (N) of the averagings as a cut-off criterion for implementation of further averagings.

**2.** Method according to claim 1,
wherein the metric L is calculated using the formula

$$L = N \cdot \frac{\left| \sum_{i=0}^{N-1} y_{1i} \cdot y_{2i}^* \right|^2}{\sum_{i=0}^{N-1} |y_{1i}|^2 \cdot \sum_{i=0}^{N-1} |y_{2i}|^2}$$

in which $y_{1i}$ is the ith value of the first Fourier-transformed signal, $y_{2i}$ is the ith value of the second Fourier-transformed signal and N is the number of the averagings.

**3.** Method according to claim 1 or 2,
wherein the method is cut off when the metric (L) is greater than a predefined threshold value (R) after at least a minimum number ($N_{min}$) of averagings has been implemented.

**4.** Method according to claim 3,
wherein the threshold value (R) is at least 10 and/or wherein the minimum number ($N_{min}$) of averagings is at least 100.

**5.** Method according to one of claims 1 to 4,
wherein the noisy input signal $(x(t)+u_1(t); x(t)+u_2(t))$ in each path (1; 2) is digitally sampled separately (5; 6),
wherein in each case a discrete Fourier transformation (7; 8) is implemented in each path (1; 2) and
wherein the metric is calculated for each bin (k) of the discrete first Fourier-transformed signal and the discrete second Fourier-transformed signal.

**6.** Method according to claim 5,
wherein the minimum of all the metrics (L(k)) calculated for all the bins (k) is used as a total metric ($L_{total}$).

**7.** Method according to claim 5,
wherein the average value of all the metrics (L(k)) calculated for all the bins (k) is used as a total metric ($L_{total}$).

**8.** Device for measuring the power density spectrum of an input signal (x(t)) with
a first Fourier transformation unit (7) which implements a first Fourier transformation in a first path (1) to generate a first Fourier-transformed signal ($y_1(k)$), a second Fourier transformation unit (8) which implements a second Fourier transformation in a second path (2) to generate a second Fourier-transformed signal ($y_2(k)$), and a cross-correlator ($9_1$, $10_1$, $9_2$, $10_2$, ..., $9_N$, $10_N$) which implements a cross-correlation of the first Fourier-transformed signal ($y_1(k)$) and the second Fourier-transformed signal ($y_2(k)$) over a number (N) of averagings,
**characterised by**
a calculating unit (33) for calculating a metric (L) from the first Fourier-transformed signal ($y_1(k)$) and the second Fourier-transformed signal ($y_2(k)$) and the already implemented number (N) of the averagings as a cut-off criterion for implementation of further averagings.

**9.** Device according to claim 8,
wherein the calculating unit (33) comprises a first square forming unit (20) for forming the square of the first Fourier-transformed signal ($y_1(k)$) and a second square forming unit (21) for forming the square of the second Fourier-transformed signal ($y_2(k)$).

**10.** Device according to claim 9,
wherein the calculating unit (33) comprises a first averaging unit (22) for averaging the output values of the first square forming unit (20) and a second averaging unit (23) for averaging the output values of the second square forming unit (21).

**11.** Device according to claim 10,
wherein the calculating unit (33) comprises a first multiplier (24) for multiplying the output values of the first averaging unit (22) and the output values of the second averaging unit (23).

**12.** Device according to claim 11,
wherein the calculating unit (33) comprises a second multiplier (26) for multiplying the first Fourier-transformed signal ($y_1(k)$) and the complex conjugate second Fourier-transformed signal ($y_2{}^*(k)$) or for multiplying the second Fourier-transformed signal ($y_2(k)$) and the complex conjugate first Fourier-transformed signal ($y_1{}^*(k)$).

**13.** Device according to claim 12,
wherein the calculating unit (33) comprises a third averaging unit (27) for averaging the output values of the second multiplier (26).

**14.** Device according to claim 13,
wherein the calculating unit (33) comprises a third square forming unit (28) for forming the square of the output values of the third averaging unit (27).

**15.** Device according to claim 14,
wherein the calculating unit (33) comprises a division unit (25) which forms the quotient of the output values of the third square forming unit (28) and the output values of the first multiplier (24).

**16.** Device according to claim 15,
wherein the calculating unit (33) comprises a third multiplier (29) for multiplying the output values of the division unit (25) with the number of averagings (N).

**Revendications**

1. Procédé pour mesurer le spectre de densité de puissance d'un signal d'entrée (x(t)), comprenant les étapes de procédé suivantes :

   laréalisation d'une première transformée de Fourier (7) dans une première voie (1) pour générer un premier signal ayant subi une transformée de Fourier ($y_1(k)$),
   laréalisation d'une deuxième transformée de Fourier (8) dans une deuxième voie (2) pour générer un deuxième signal ayant subi une transformée de Fourier ($y_2(k)$),
   laréalisation d'une corrélation croisée ($9_1$, $10_1$, $9_2$, $10_2$, ..., $9_N$, $10_N$) à partir du premier signal ayant subi une transformée de Fourier ($y_1(k)$) et du deuxième signal ayant subi une transformée de Fourier ($y_2(k)$) par l'intermédiaire d'un certain nombre (N) de calculs de la moyenne,
   **caractérisé par**
   le calcul (33) d'une métrique (L) à partir du premier signal ayant subi une transformée de Fourier ($y_1(k)$) et du deuxième signal ayant subi une transformée de Fourier ($y_2(k)$) ainsi que du certain nombre (N) de calculs de la moyenne déjà réalisés comme critère d'interruption pour la réalisation d'autres calculs de la moyenne.

2. Procédé selon la revendication 1,
   dans lequel la métrique L est calculée selon la formule

$$L = N \cdot \frac{\left| \sum_{i=0}^{N-1} y_{1i} \cdot y_{2i}^{*} \right|^2}{\sum_{i=0}^{N-1} |y_{1i}|^2 \cdot \sum_{i=0}^{N-1} |y_{2i}|^2}$$

   dans lequel $y_{1i}$ est la ième valeur du premier signal ayant subi une transformée de Fourier, $y_{2i}$ la ième valeur du deuxième signal ayant subi une transformée de Fourier et N le nombre des calculs de la moyenne.

3. Procédé selon la revendication 1 ou 2,
   dans lequel le procédé est interrompu lorsque la métrique (L) est supérieure à une valeur seuil (R) prédéfinie, après qu'au moins un nombre minimal ($N_{min}$) de calculs de la moyenne a été réalisé.

4. Procédé selon la revendication 3,
   dans lequel la valeur seuil (R) atteint au moins 10 et/ou dans lequel le nombre minimal ($N_{min}$) de calculs de la moyenne atteint au moins 100.

5. Procédé selon l'une quelconque des revendications 1 à 4,

   dans lequel le signal d'entrée enfoui dans un bruit ($x(t)+u_1(t)$ ; $x(t)+u_2(t)$) est échantillonné (5 ; 6) séparément de façon numérique dans chaque voie (1 ; 2),
   dans lequel une transformée de Fourier discrète (7 ; 8) est réalisée respectivement dans chaque voie (1 ; 2) et
   dans lequel la métrique est calculée pour chaque groupe (k) du premier signal ayant subi une transformée de Fourier discrète et du deuxième signal ayant subi une transformée de Fourier discrète.

6. Procédé selon la revendication 5,
   dans lequel le minimum de toutes les métriques (L(k)) calculées pour tous les groupes (k) est utilisé comme métrique totale ($L_{gesamt}$).

7. Procédé selon la revendication 5,
   dans lequel la valeur moyenne de toutes les métriques (L(k)) calculées pour tous les groupes (k) est utilisée comme métrique totale ($L_{gesamt}$).

8. Dispositif pour mesurer le spectre de densité de puissance d'un signal d'entrée (x(t)), comprenant un premier dispositif de transformée de Fourier (7), qui réalise une première transformée de Fourier dans une première voie (1) pour générer un premier signal ayant subi une transformée de Fourier ($y_1(k)$), un deuxième dispositif de transformée de Fourier (8), qui réalise une deuxième transformée de Fourier dans une deuxième voie (2) pour générer un deuxième signal ayant subi une transformée de Fourier ($y_2(k)$), et un corrélateur croisé ($9_1$, $10_1$, $9_2$, $10_2$, ..., $9_N$, $10_N$), qui réalise une corrélation croisée à partir du premier signal ayant subi une transformée de Fourier ($y_1(k)$) et du deuxième signal ayant subi une transformée de Fourier ($y_2(k)$) par l'intermédiaire d'un certain nombre (N) de calculs de la moyenne,

**caractérisé par**

un dispositif de calcul (33) destiné à calculer une métrique (L) à partir du premier signal ayant subi une transformée de Fourier ($y_1(k)$) et du deuxième signal ayant subi une transformée de Fourier ($y_2(k)$) ainsi que du certain nombre (N) de calculs de la moyenne déjà réalisés comme critère d'interruption pour la réalisation d'autres calculs de la moyenne.

9. Dispositif selon la revendication 8,
dans lequel le dispositif de calcul (33) comprend un premier dispositif de formation de module au carré (20) destiné à former le module au carré du premier signal ayant subi une transformée de Fourier ($y_1(k)$) et un deuxième dispositif de formation de module au carré (21) destiné à former le module au carré du deuxième signal ayant subi une transformée de Fourier ($y_2(k)$).

10. Dispositif selon la revendication 9,
dans lequel le dispositif de calcul (33) comprend un premier dispositif de calcul de la moyenne (22) destiné à calculer la moyenne des valeurs de sortie du premier dispositif de formation de module au carré (20) et un deuxième dispositif de calcul de la moyenne (23) destiné à calculer la moyenne des valeurs de sortie du deuxième dispositif de formation de module au carré (21).

11. Dispositif selon la revendication 10, dans lequel le dispositif de calcul (33) présente un premier multiplicateur (24) destiné à multiplier les valeurs de sortie du premier dispositif de calcul de la moyenne (22) et les valeurs de sortie du deuxième dispositif de calcul de la moyenne (23).

12. Dispositif selon la revendication 11,
dans lequel le dispositif de calcul (33) présente un deuxième multiplicateur (26) destiné à multiplier le premier signal ayant subi une transformée de Fourier ($y_1(k)$) et le deuxième signal ayant subi une transformée de Fourier complexe conjugué ($y_2^*(k)$) ou à multiplier le deuxième signal ayant subi une transformée de Fourier ($y_2(k)$) et le premier signal ayant subi une transformée de Fourier complexe conjugué ($y_1^*(k)$).

13. Dispositif selon la revendication 12,
dans lequel le dispositif de calcul (33) comprend un troisième dispositif de calcul de la moyenne (27) destiné à calculer la moyenne des valeurs de sortie du deuxième multiplicateur (26).

14. Dispositif selon la revendication 13,
dans lequel le dispositif de calcul (33) comprend un troisième dispositif de formation de module au carré (28) destiné à former le module au carré des valeurs de sortie du troisième dispositif de calcul de la moyenne (27).

15. Dispositif selon la revendication 14,
dans lequel le dispositif de calcul (33) comprend un dispositif de division (25), qui forme le quotient des valeurs de sortie du troisième dispositif de formation de module au carré (28) et des valeurs de sortie du premier multiplicateur (24).

16. Dispositif selon la revendication 15,
dans lequel le dispositif de calcul (33) comprend un troisième multiplicateur (29) destiné à multiplier les valeurs de sortie du dispositif de division (25) par le nombre des calculs de la moyenne (N).

Fig. 1

Fig. 2

Fig. 3

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20050238094 A1
- GB 2426597 A